# EUROPEAN PATENT APPLICATION

(11) **EP 1 094 576 A1**
(43) Date of publication of application: **25.04.2001**
(21) Application number: 98958256.4
(22) Date of filing: 03.12.1998
(51) Int. Cl.: H02B 1/30, H05K 7/18

(54) **CLOSET FOR COMPUTER EQUIPMENT**

(30) Priority: 23.06.1998 ES 9801312; 25.09.1998 ES 9802010
(71) Applicant: Gesab, S.A., 08400 Granollers (ES)
(72) Inventor: SABATE GARCIA, Pere, E-08459 Sant Antoni De Vilamajor (ES)
(74) Representative: Evens, Paul Jonathan
(86) International application number: ES9800330
(87) International publication number: WO9967858

(57) **Abstract**

Closet for computer equipment in which, inside the space defined by the corresponding structure (1), in at least one of the sides, an accessory area (3) is determined dedicated to the disposition and assembly of the electrification, incorporating in the mentioned area (3) some vertical bars (4) foreseen at the edge with a perforated correlation (6), serving as supports for the fastening of respective vertical chutes (5) and susceptible traverse elements, which can be incorporated in variable number and according to any distribution in heights.

## Description

The multiplicity of devices, components of computer equipment, as well as all the cables necessary for the electric feeding and interconnection, present serious problems for the appropriate organization of this equipment so that the whole set remains withdrawn in a reduced, collected and manageable way.

In that sense, structures have been developed as a kind of shelves to install the devices in an orderly way, persisting however the problem of those cables whose collection and concealment within the facilities still has to be solved in a satisfactory way.

The problem is the bigger when what is sought is to include these organization dispositions inside the structures by way of closets, since in this case the wiring practically prevents the covering structure to remain completely closed.

According to the present invention, a closet is proposed in which a disposition is foreseen which allows to solve the mentioned problem in a very advantageous way.

This closet, object of the invention, includes a conventional structure which allows the orderly disposition of the component devices of any computer, electronic or mechanical set, but in such a way that a service area remains determined in at least one of the sides inside the closet itself where some flat vertical bars are fastened on the structure frame and on which in turn both chutes are incorporated which extend over the whole height of the closet.

These vertical bars present an edge with a perforated correlation over the whole length, allowing the fastening on them of traverse elements, such as chutes and boards, as well as small devices and the necessary components for the electrification of the equipment, being the number and the distribution of those traverse elements variable in function of the needs of each application set.

This way a closet is obtained with an interior side area in which the incorporation in a collected and orderly way of the whole set of cables and electrification elements belonging to the application set is possible, easing up the assembly of the installation, as well as the access for any manipulation which may be necessary later on; everything without damaging the closure of said closet side by means of a cover which can be removed to gain access to the installation.

At the front of the closet, through which the devices of the application equipment are introduced, a structural bar is moreover provided, vertically in the part corresponding to the mentioned side area of the installation housing, with a series of by-pass openings to the referred lateral area, through which openings the cable passage corresponding to the front connections of the devices of application can be established.

This way the closet can be closed at its front with a covering door without the least inconvenience; being foreseen to such an effect a door with a convexing towards the outside, to overcome the front of the necessary cables and devices without any harming effect.

The top and the base of the closet are in turn provided with some openings that correspond to the mentioned lateral housing area of the installation, and which allow the entrance of external cables through the mentioned top and base of the closet, favouring the electrification by means of the cables coming from false ceilings or any installation established at high level, as well as from facilities situated below the floor.

According to a practical realization the closet is built up in a double composition, consisting in two independent bodies, which are established hingedly joined to each other insusceptible disassembling, to remain juxtaposed one against the other, establishing the closing of the respective lateral service areas between them, with the possibility to open the mentioned areas by means of the articulated turning of the mentioned bodies.

The component bodies of the closet are foreseen with rolling supports, which ease up the sliding displacement of the set, for the situation where it is wanted, allowing in turn an easy mobility of the bodies in their articulation for the opening and closing of the set.

This way a closet group is obtained with great capacity to house the component elements of the equipment to be installed, with easy access to the service areas dedicated to the electrification, whose closing does not require any accessory covers, but it is rather established by the simple juxtaposition of the closet bodies.

The articulation between the closet bodies can be by means of direct hinging or by means of some articulated arms which allow a bigger opening separation, easing up this way the manipulations that have to be carried out inside the service areas.

The incorporation of a tray mounted on guides is also foreseen in the closet bodies, with possibility to be extracted by sliding them towards the front, building up this tray a concavity in which one or more keyboards can be housed, while at the front part it defines an evened area at the upper level, in which a depression is determined dedicated to the fitting of a computer mouse pad.

This way the closet offers in turn some ideal conditions for the operation of the equipment installed in its interior, both for the optimum disposition of the keyboard access and the handling mouse, and for the immobility of the elements in their corresponding place.

In view of which the mentioned closet object of the invention certainly has some very advantageous characteristics, acquiring by itself life characteristic and preferable character for the application to which it is dedicated.

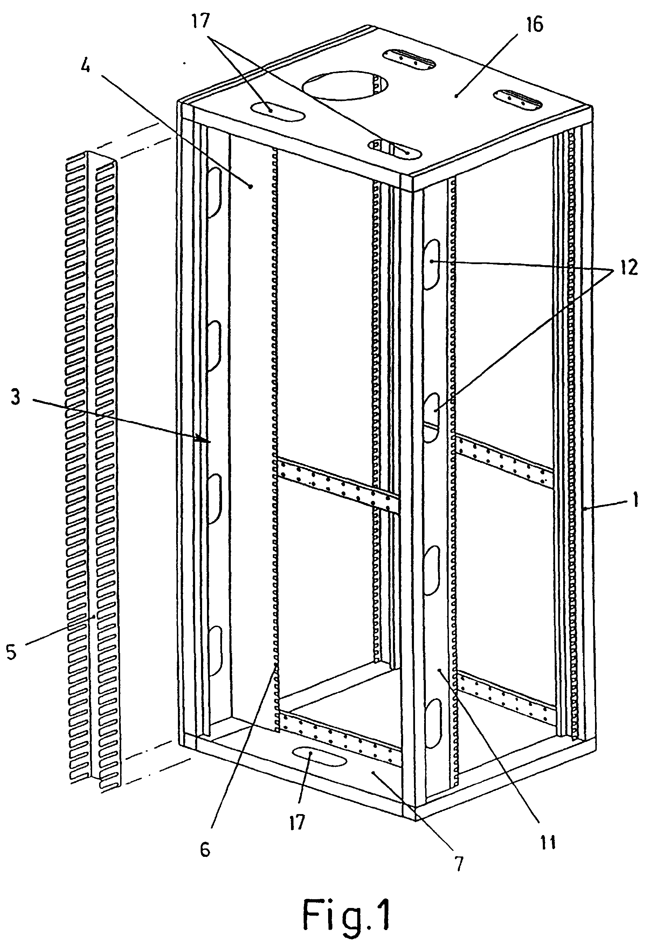

Figure 1 represents a perspective of the structural group of the preconized closet, with one of the vertical chutes which can be incorporated in the side area of the installation lodging, positioned in front of their assembly situation.
Figure 2 is a perspective of the closet including an applicational equipment with the front door of the closet opened and the side of installation housing uncovered.

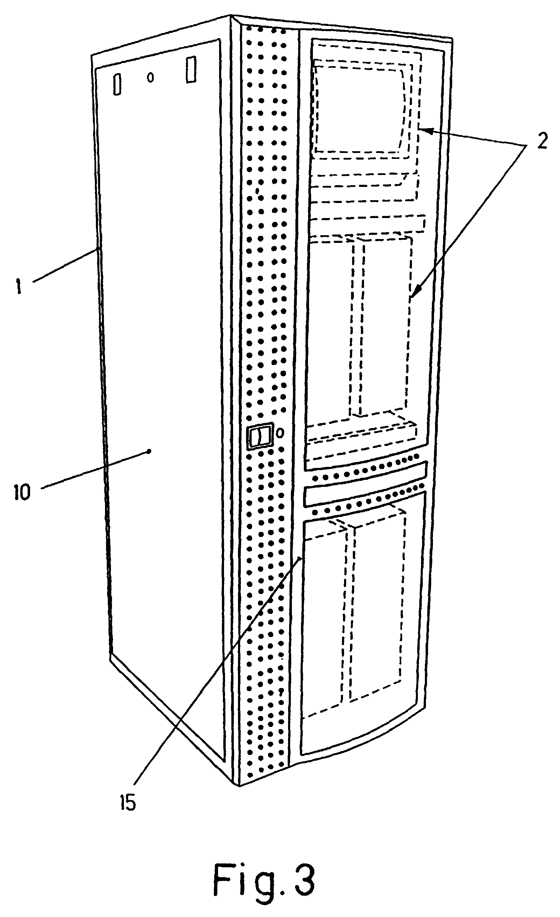

Figure 3 is a perspective of the completely closed closet according to the same application example of the previous figure.
Figure 4 represents a perspective of the structural set of a closet with double body, according to the invention, with the two component bodies articulately united by means of a direct hinging.
Figure 5 is a similar perspective to the previous one, with the component bodies of the closet joined by means of articulation suspenders.
Figure 6 is a detail in enlarged perspective showing the disposition of a keyboard tray in a closet body.

The object of the invention refers to a closet dedicated to the organization of computer equipment susceptible of also being applied for electronic or mechanical sets, in particular in accordance with a foreseen realization so that those cables and elements belonging to the electrification can be incorporated in a convenient way inside the closet itself.

The closet consists in a conventional structure (1), by means of which a variable internal organization can be determined in heights, for the incorporation of the devices (2) components of the application set in each case.

In accordance with the invention, inside the space corresponding to the interior enclosure of the closet, in at least one of the sides, an area (3) is determined dedicated to the assembly of the electric installation to connect the devices (2), components of the application set and the necessary elements for the electrification of the set.

In the mentioned area (3) in fixed fastening with respect to the structural group (1) of the closet some flat vertical bars (4) are situated on which both chutes (5) which extend over the whole height of the closet are fixed. The mentioned chutes (5) remain with their open part orientated towards the outside, they can be left uncovered or the closure of the same can be established by means of the incorporation of the corresponding covers.

The flat bars (4) have at their edge a perforated correlation (6) along the whole length, allowing, by means of this perforated correlation (6) the fastening by means of a hook or by screwing of the elements which can be incorporated at the suitable assembly height.

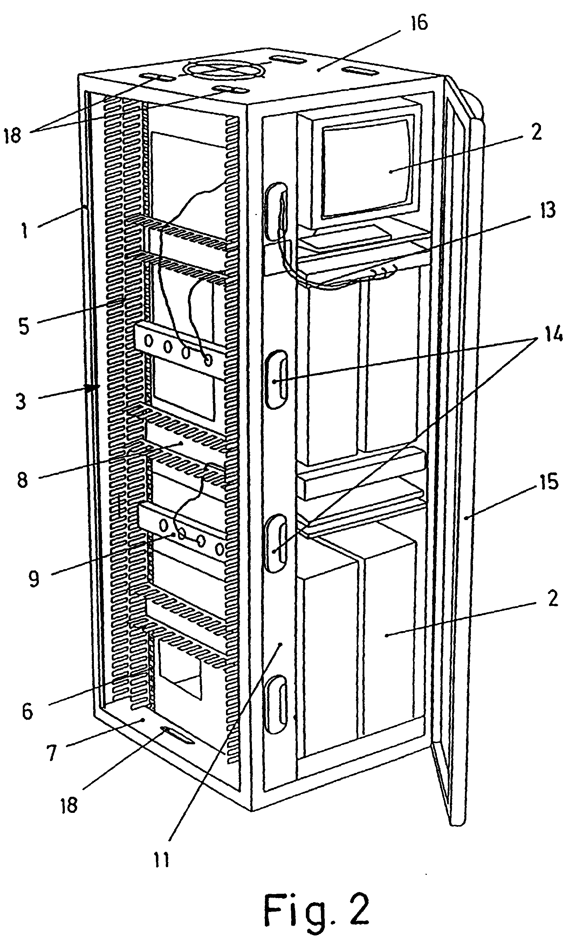

This way any kind of elements and / or devices with small dimensions, and which belong to the composition set or the installation of the equipment can be incorporated; and also, in direct fixing on the perforated correlations (6) of the vertical bars (4), some horizontal chutes (8) can be incorporated for the cable passage to establish the connection and electric installation of the equipment, as well as other elements of the electrification assembly, such as connecting boards or bases (9) as can be observed in figure 2.

This way a service area located inside the space defined by the structure (1) of the closet, where the disposition and placement, of the cables and elements of the electric installation of the application set and even small devices of the composition of the corresponding equipment can be carried out in a collected and orderly way, which favours the assembly of the installation, remaining everything moreover in a perfect disposition for the technical interventions of maintenance, repair, or of any other type which have to be carried out on the mentioned installation later on.

The area (3) in which the service area is determined is susceptible of being closed with a cover (10), constituent of the side of the closet frame, with which the whole functional and application set assembly remains perfectly contained inside the closet, with access possibility to the installation by means of the retreat of the mentioned cover (10) to close the area (3).

Anyway the same disposition can be established on both sides of the closet; for which it is only necessary to dimension the structure (1) according to the necessary width to determine the corresponding areas (3) in the sides and between them the space dedicated to the organization of the devices (2) of the equipment to be installed in the closet.

At the front, through which the access for the insertion of the device (2) of the application set remains defined, it also incorporates a structural bar (11), in a vertical correlation to the part that corresponds with the side area (3). In this bar a series of openings (12) are defined, which allow the passage without inconvenience, till the assembly side area (3), of the cables (13) corresponding to connections that have to be established on the front part of the devices (2). The mentioned openings (12) are closed by means of cable bushings (14) through which the cable (13) passage is carried out.

That disposition facilitates the front closing of the closet by means of a door (15) without being this any nuisance to place it in the closed position, since the cables (13) do not leave to the outside. According to a preferable realization the incorporation of a warped door (15) is foreseen with convexing towards the outside, since this way any obstacle that can be supposed at the front of the devices (2) can perfectly be surpassed as well as the necessary cables, being able to close it without the least difficulty.

In accordance with a particularity, in the top (16) of the closet and in its base (7), some openings (17) are also foreseen in which cable bushings (18) can also be installed and with which the direct access is possible to the interior installation situated in the area (3), of external cables for the connection and/or electric feeding, from upper facilities, such as those that are usually included through false ceilings, or from inferior facilities spread on the floor or below it.

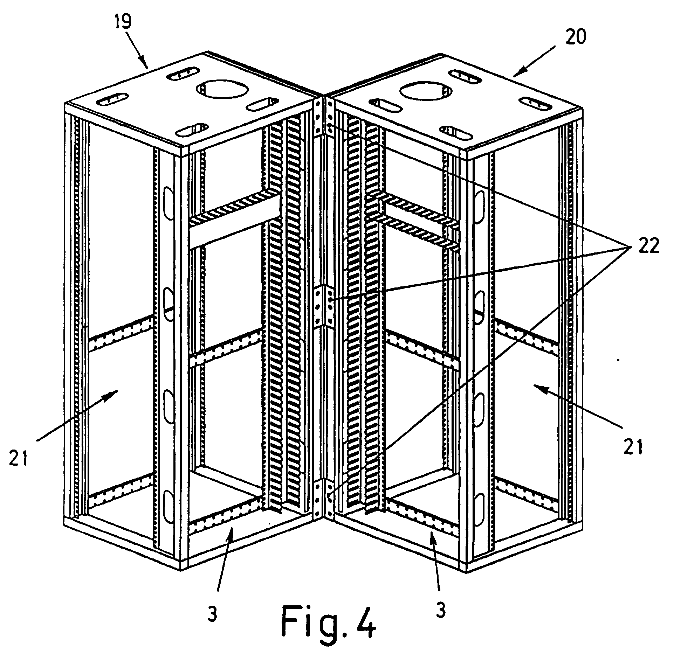

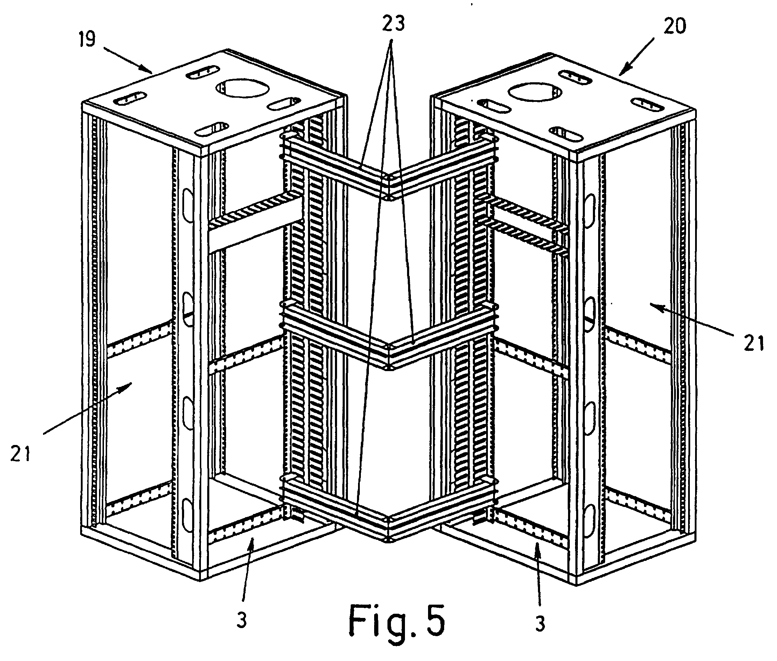

In accordance with a realization the closet can also be determined according to a structural group built up of two independent closet bodies (19) and (20), in the way represented on figures 4 and 5, defining each of these bodies (19) and (20) a general enclosure (21) for the housing of the component elements of the application sets and in a side the area (3) dedicated to housing the wiring and electrification elements.

The mentioned closet bodies (19) and (20) are established articulatedly united one to the other, so that a tiltable play is susceptible between them, with the possibility of being lowered one against the other to remain laterally juxtaposed, establishing this way a reciprocal closing of the corresponding lateral areas (3) of electrification housing.

The mentioned bodies (19) and (20) are foreseen with rolling supports on the floor, thanks to which a mobile sliding is easily realizable for the juxtaposition of both bodies (19) and (20), or the separation of these by turning them on their articulate union; being therefore realizable the closing and the opening of the areas (3) by means of the simple sliding of the bodies (19) and (20) by turning them on their articulation.

The articulate union between the bodies (19) and (20) can be established directly by means of hinges (22) just as it is represented on figure 4, this articulate union can also be established by means of articulate arms (23), in the way represented on figure 5, with which when they area opened a greater separation capacity of the bodies (19) and (20) is obtained, facilitating this way a better access to the areas (3) for the assembly operations and for the maintenance of the electrification later on.

In any event, the bodies (19) and (20) can be united by any means able to establish a solidary relationship between them, with the possibility to be tilted between a corresponding side juxtaposition determinant of the closure of the respective areas (3) and a separation by turning so as to leave these areas (3) uncovered.

The number of the joining elements, be it hinges (22), articulate suspenders (23), or any other means, which in turn can vary in function of the size of the bodies (19) and (20), so that the union has the appropriate resistance.

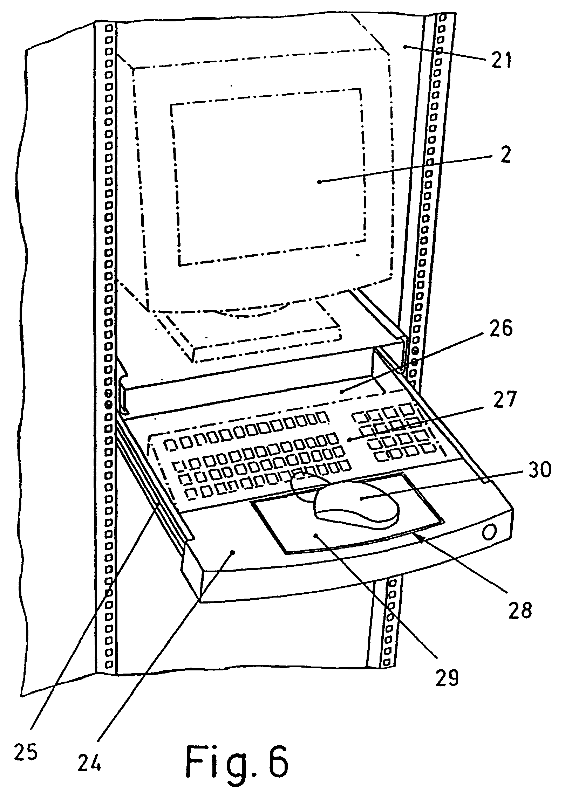

In the component (2) housing enclosure (21) of the application set, as represented on figure 6, the incorporation of a tray (24) is foreseen mounted on guides (25) that allow the sliding in extraction towards the front and its retraction in concealment towards the inside.

It is foreseen that the mentioned tray (24) builds up a concavity (26) where one or more keyboards (27) can be situated while in the front part an evened area is defined at the upper level, in which a depression exists (28) that serves to house a pad (29) for the computer mouse, which is this way evened with the tray surface (24) and moreover inserted, without movement possibility when managing on it the corresponding mouse (30).

The keyboards (27) remain on the other hand also perfectly assured, so that they do not move during their use, thanks to the housing in the concavity (26) which determines an immobilization fitting.

## Claims

1. Closet for computer equipment, characterized because inside the space defined by the closet structure (1) an accessory area (3) is determined in at least one of the sides in function of the service area dedicated to the disposition and assembly of the electrification, incorporating in the mentioned area (3) some flat vertical bars (4) which serve as supports for the fastening of respective vertical chutes (5) and susceptible traverse elements such as horizontal chutes (8) for the passage of the cables and small elements and devices of the installation; being susceptible the closing of the mentioned area (3) by means of a cover (10) by way of a collapsible cover.

2. Closet for computer equipment, according to the first claim, characterized because the vertical bars (4) determine an edge with a perforated correlation (6), by means of which the direct fastening on them of the traverse elements is allowed, by diverse means, and which can be incorporated in variable number and according to the distribution at the heights that are of interest.

3. Closet for computer equipment, in according to the first claim, characterized because at the front part, laterally regarding the inclusion area of the devices (2) of the application set, correlatively in correspondence with the lateral area (3), a structural bar (11) is incorporated, in which a series of openings (12) are defined through which the cables (13) for front connections can be passed until the mentioned side area (3) of the installation housing.

4. Closet for computer equipment,according to the first claim, characterized because in the top (16) and on the base (7) of the closet some openings (17) are foreseen, through which the direct access to the interior installation located in the area (3) of the external cable for the connection and/or electric feeding is possible from upper facilities, such as those that go through false ceilings or from lower facilities spread over the floor or below it.

5. Closet for computer equipment, according to claims 1 and 3, characterized because in the front part of the closet a closing door (15) is incorporated which is foreseen with a warped form in convexing outwards and allowing to overcome the front of the applied devices (2) and the necessary cables, closing without any difficulty.

6. Closet for computer equipment, according to the first claim, characterized because according to a realization the closet is built up of a structural set that includes two independent closet bodies (19) and (20), which establish, articulatedly united to one another, a revolvable tilting play between them, with the possibility of being lowered in lateral juxtaposition one against the other, determining in its confrontation the closure of the corresponding side areas (3) being realizable the opening for the access to the mentioned areas (3) by turning the mentioned bodies (19) and (20) on the articulation.

7. Closet for computer equipment, according to claim 6, characterized because the articulation between the component bodies (19) and (20) is established through direct union by means of hinges (22).

8. Closet for computer equipment, according to claim 6, characterized because the articulation between the component bodies (19) and (20) is established by means of articulate suspenders (23), which determine a separation distancing between the mentioned bodies (19) and (20) when opening.

9. Closet for computer equipment according to claim 6, characterized because the bodies (19) and (20), components of the closet, are incorporated on rolling supports, which ease up the sliding of the mentioned bodies (19) and (20) in their turning on the articulation for the opening and closing of the set.

10. Closet for computer equipment, according to the first claim, characterized because in the enclosure to lodge the components (2) of the application set, a tray is included (24) which is incorporated on guides (25) sliding towards the inside and towards the outside, determining the mentioned tray (24) a concavity (26), in which one or more keyboards (27) can be fitted, while at the front part it determines an evened area at the upper level, in which a depression (28) is defined, susceptible of housing an inserted pad (29) for a computer mouse.
